# EUROPEAN PATENT APPLICATION

(11) **EP 2 065 948 A2**
(43) Date of publication of application: **03.06.2009**
(21) Application number: 08020468.8
(22) Date of filing: 25.11.2008
(51) Int. Cl.: H01L 33/00

(54) **Semiconductor light emitting device and lighting device**

(30) Priority: 28.11.2007 JP 2007307675
(71) Applicant: Stanley Electric Co., Ltd., Meguro-ku Tokyo 153-8636 (JP)
(72) Inventor: Sato, Masanori, Tokyo (JP); Harada, Mitsunori, Tokyo (JP); Ueno, Kajzuhiko, Tokyo (JP)
(74) Representative: Wagner, Karl H.

(57) **Abstract**

A semiconductor light emitting device (100) can include a light emitting element (3) with a semiconductor epitaxial layer (2) which has a light emitting portion, and an element substrate (1) which supports the semiconductor epitaxial layer (2) and does not transmit light from the light emitting portion. A resin layer (4) can be provided on the element substrate (1) in a way covering side surfaces and an upper surface of the semiconductor epitaxial layer (2). The resin layer (4) can contain fluorescent substances (5) that wavelength-convert light from the light emitting portion, and can be inclined toward the top at one cross section. Therefore, the semiconductor light emitting device can exhibit a front luminance distribution having a difference in front luminance between the light emitting portion and the light non-emitting portion at an end portion of the semiconductor light emitting device.

## Description

### BACKGROUND OF THE INVENTION

### Field of the Invention

The presently disclosed subject matter relates to a semiconductor light emitting device, which in particular is provided with a resin layer containing light-scattering materials and/or fluorescent substances, and lighting devices incorporating the same.

### Description of the Related Art

Currently, with blue light emitting elements becoming popular for high-power and high luminance applications, white light emitting devices, in which a part of light emitted from a blue light emitting element is wavelength-converted by fluorescent substance (e.g., fluorescent particles), have come to be used in lighting equipment such as general lighting fixtures, street lights, vehicle headlamps and so forth.

As a kind of a light source that uses a light emitting element, there is a semiconductor light emitting device having a resin layer, which contains fluorescent substances, provided on the light emitting element (see for example, Japanese Patent Application Laid-Open No. 2002-185048 and Japanese Patent Application Laid-Open No. 2001-244507).

With respect to lighting equipment, such as general lighting, street lights, headlamps, etc., it is typical that a difference in front luminance between a light emitting portion and a light non-emitting portion of the light source is large depending on the intended use, the desired light distribution characteristic, and the kind of lens design adopted.

### SUMMARY OF THE INVENTION

However, in the semiconductor light emitting device disclosed in Japanese Patent Application Laid-Open No. 2002-185048, since the resin layer containing the fluorescent substance covers the light emitting element and has a uniform thickness, light will be emitted from side surfaces of the resin layer in a horizontal direction and in directions lower than the horizontal direction, whereby the front luminance of an end portion of the semiconductor light emitting device will deteriorate. Accordingly, the front luminance distribution of the semiconductor light emitting device will have a broad form, and thus there might be cases in which such semiconductor light emitting device is not qualified for use as a light source depending on the desired optical light distribution.

Moreover, in the semiconductor light emitting device disclosed in Japanese Patent Application Laid-Open No. 2001-244507, since the resin layer containing the fluorescent substance is arranged on the light emitting element in a rectangular shape at cross section, light emitted from side surfaces of the resin layer will be reflected by a substrate where the semiconductor light emitting device is being mounted on. As a result, a surface of the substrate will glow, whereby the front luminance of an end portion of the semiconductor light emitting device will not rise precipitously. Thus, there might be cases in which such semiconductor light emitting device is not qualified for use as a light source depending on the desired optical light distribution.

Furthermore, a high-power semiconductor light emitting device with a high-power density, for instance, over 2 (W/mm²), will sometimes have problems regarding not only increased temperature of the light emitting element, but also increased heat generated by the fluorescent substance itself contained in the resin layer. Due to the heat generated by the fluorescent substance, conversion efficiency of the fluorescent substance at the time of wavelength conversion of light from the light emitting element will deteriorate to a considerable extent. In addition, there might be cases in which a part of a transparent resin composing the resin layer will volatilize to cause a decrease in the volume of the transparent resin and/or blackening of the transparent resin, whereby performance of the semiconductor light emitting device may deteriorate to a considerable extent.

The presently disclosed subject matter is provided in view of such circumstances, and can include a semiconductor light emitting device having a resin layer containing light-scattering materials and/or fluorescent substance, which exhibits a front luminance distribution where there is a large difference in front luminance between a light emitting portion and a light non-emitting portion at an end portion of the semiconductor light emitting device.

Furthermore, according to the disclosed subject matter, a semiconductor light emitting device can include a resin layer containing fluorescent substance, and the light emitting device can be configured to be capable of efficiently diffusing heat generated by the fluorescent substance contained in the resin layer.

In accordance with another aspect of the disclosed subject matter, a semiconductor light emitting device can include a light emitting element including a semiconductor epitaxial layer which has a light emitting portion, and an element substrate which supports the semiconductor epitaxial layer and does not transmit light from the light emitting portion. A resin layer can be provided on the element substrate in a way covering side surfaces and an upper surface of the semiconductor epitaxial layer and containing scattering materials and/or fluorescent substance configured to wavelength-convert the light from the light emitting portion, the resin layer being inclined inwardly toward the top at one cross section.

According to the above aspect of the presently disclosed subject matter, firstly, by using the element substrate which does not transmit light from the light emitting portion, the light from the light emitting portion is prevented from leaking through the element substrate to a side of a substrate where the light emitting element is mounted on, whereby possible reflected light from the substrate can be prevented. Secondly, since the resin layer is inclined inwardly toward the top at one cross section, it is possible to prevent a front luminance of an end portion of the semiconductor light emitting device from deteriorating because the light from side surfaces of the resin layer does not emit in a horizontal direction and in directions lower than the horizontal direction.

As a result, it is possible to achieve a semiconductor light emitting device having a front luminance distribution where there is a large difference in front luminance between a light emitting portion in the semiconductor light emitting device and a light non-emitting portion in the outside.

In a semiconductor light emitting device made in accordance with principles of the presently disclosed subject matter, the resin layer can be formed in an inclined manner and in the form of an approximate arc at one cross section.

Since the surface of the resin layer is inclined in a form of an approximate arc, the semiconductor light emitting device can achieve a light distribution pattern having few extreme highs and lows in luminance.

The resin layer can be formed in a way such that an angle formed between a tangent line of the resin layer, drawn on a starting point of inclination of the resin layer, and a surface of the element substrate is 20 degrees or over but not exceeding 90 degrees, at one cross section.

As long as the angle formed between the tangent line of the resin layer and the surface of the element substrate is 20 degrees or over but not exceeding 90 degrees, it is possible to obtain a desired front luminance distribution.

The resin layer can also be formed to include scattering materials and/or a fluorescent substance delivered by drops to harden thereafter.

By forming the resin to include scattering materials and/or a fluorescent substance delivered by drops to harden thereafter, a resin layer inclined in an approximate arc form can be easily realized.

The resin layer can also be arranged such that it contains scattering materials and fluorescent substance while the resin layer has a laminated structure composed of a layer containing scattering materials and a layer containing a fluorescent substance.

Since the resin layer has the laminated structure composed of the layer containing scattering materials and the layer containing fluorescent substance, it is possible to obtain a desired light emitting profile and emission color by adjusting the thickness and the content rate of each layer.

The element substrate that does not transmit light can be configured, for example, as an opaque substrate which absorbs light from the light emitting portion, a substrate which reflects the light from the light emitting portion, and/or a semiconductor substrate having a reflective layer laminated thereon.

Accordingly, it is possible to prevent the light from the light emitting portion from being transmitted through the element substrate and reflected by a mounting substrate.

It is also possible to have a front luminance distribution exhibiting a maximum value of front luminance at an end portion where a surface of the resin layer starts to incline.

The front luminance distribution can exhibit a maximum value of front luminance at the end portion where the surface of the resin layer starts to incline. The condition where the maximum value of front luminance is obtained at the end portion includes a state in which the front luminance of a center portion is the same as the front luminance of the end portion in the front luminance distribution. This means that it is appropriate as along as the front luminance of the center portion is not higher than the front luminance of the end portion.

It is also possible to have a front luminance distribution where a luminance ratio of a maximum value of front luminance to a value of front luminance with respect to a part other than the light emitting surface is at least 150:1.

Since the luminance ratio of the maximum value of front luminance to the value of front luminance with respect to the part other than the light emitting surface is at least 150:1 in the front luminance distribution, when the semiconductor light emitting device is used as a lighting device, and as a vehicle front light in particular, it is possible to have a sharp boundary line between the light emitting portion and the light non-emitting portion.

The resin layer can also be arranged such that it contains fluorescent substance deposited on the light emitting element.

Accordingly, in addition to obtaining a precipitous front luminance distribution, it is possible to efficiently diffuse the heat generated by the fluorescent substance. Since the fluorescent substance in the resin layer can include a plurality of particles deposited on the light emitting element, the heat generated by the fluorescent substance will be transmitted to the light emitting element without being passed on to the transparent resin with low thermal conductivity, whereby the heat can be efficiently diffused.

In accordance with another aspect of the presently disclosed subject matter, it is possible to have the fluorescent substance deposited on the light emitting element via a sedimentation process.

Since the fluorescent substance within the resin layer can be deposited on the light emitting element by sedimentation, the fluorescent substance can be deposited evenly on the light emitting element. Thereby, the heat generated by the fluorescent substance can be efficiently transmitted to the side of the light emitting element.

In a semiconductor light emitting device of the presently disclosed subject matter, the resin layer can be arranged such that it contains fluorescent substance particles having a smaller particle size than that of the fluorescent substance deposited on the light emitting element, the fluorescent substance with the smaller particle size being dispersed within the resin layer.

Since the fluorescent substance particles having the smaller particle size are dispersed within the resin layer, it is possible to reduce unevenness of color at the time when light is to be emitted by the semiconductor light emitting device.

The resin layer can be arranged such that it contains scattering materials which are dispersed within the resin layer.

Since the scattering materials are dispersed within the resin layer, it is further possible to reduce unevenness of color at the time when light is to be emitted by the semiconductor light emitting device.

According to another aspect of the presently disclosed subject matter, a lighting device can include: the semiconductor light emitting device as described above; and a projection device which emits an output light from the semiconductor light emitting device in a predetermined direction.

Since the semiconductor light emitting device having a front luminance distribution showing a large difference in front luminance between the light emitting portion and the light non-emitting portion at the end portion of the semiconductor light emitting device is used as a light source, a light distribution pattern with a sharp light-dark boundary can be obtained.

Accordingly, it is possible to have a luminance in the vicinity of one long side of the semiconductor light emitting device illuminating an upper side of a light distribution pattern exhibit a maximum value.

With respect to the lighting device, in a case when it is used as a vehicle head light, the horizontal line in the light distribution pattern and the boundary with the precipitous front luminance distribution with respect to the above-described semiconductor light emitting device can coincide. Accordingly, in this case, it is possible to have a horizontal line with a sharp light-dark boundary under a low beam condition.

Accordingly, it is possible to realize a semiconductor light emitting device, provided with a resin layer containing scattering materials and/or fluorescent substance, which has a front luminance distribution exhibiting a large difference in front luminance between a light emitting portion and a light non-emitting portion at an end portion of the semiconductor light emitting device.

Furthermore, it is possible to realize a semiconductor light emitting device, provided with a resin layer containing fluorescent substance, which is capable of efficiently diffusing heat generated by the fluorescent substance contained in the resin layer.

### BRIEF DESCRIPTION OF THE DRAWINGS

Fig. 1 is a perspective view showing a semiconductor light emitting device made in accordance with principles of the presently disclosed subject matter;
Fig. 2A is a sectional view of the semiconductor light emitting device taken along line 2A-2A in Fig. 1, whereas Fig. 2B is a diagram showing a front luminance distribution of a semiconductor light emitting apparatus having the light emitting device mounted on a mounting board;
Figs. 3A and 3B are partial cross sectional views illustrating various conventional art light emitting devices, while Fig. 3C is a partial cross-sectional view of an exemplary light emitting device made in accordance with principles of the presently disclosed subject matter;
Fig. 4A is a graphic representation showing a relationship between a shape of a resin layer and a front luminance distribution, whereas Figs. 4B and 4C are schematic diagrams showing conditions when simulation shown in Fig. 4A is performed;
Fig. 5A is a graphic representation showing a relationship between a height of a resin layer and a front luminance distribution, whereas Figs. 5B and 5C are schematic diagrams showing conditions when simulation shown in Fig. 5A is performed;
Fig. 6A is a graphic representation showing a front luminance distribution of a semiconductor light emitting device having a resin layer of a sheet form and a resin layer of an approximately hemispherical shape, whereas Fig. 6B is a schematic diagram showing conditions when simulation shown in Fig. 6A is performed;
Figs. 7A and 7B are sectional views showing embodiments of a semiconductor light emitting device made in accordance with principles of the presently disclosed subject matter;
Figs. 8A to 8E are schematic diagrams showing embodiments of a semiconductor light emitting device made in accordance with principles of the presently disclosed subject matter;
Figs. 9A to 9C are schematic diagrams showing embodiments of a semiconductor light emitting device made in accordance with principles of the presently disclosed subject matter;
Figs. 10A to 10D are graphic representations showing a relationship between the amount of scattering materials and a front luminance distribution;
Fig. 11 is a graphic representation showing a relationship between a surface temperature of a resin layer and a Tj calculation value;
Fig. 12A is a schematic diagram showing an example of a semiconductor light emitting apparatus using semiconductor light emitting devices made in accordance with principles of the presently disclosed subject matter, whereas Fig. 12B is a schematic diagram showing an embodiment of a lighting device (vehicle lamp) according to the presently disclosed subject matter, and Fig. 12C is a schematic diagram showing another example of a semiconductor light emitting apparatus using semiconductor light emitting devices made in accordance with principles of the presently disclosed subject matter; and
Fig. 13 is a diagram showing one example of a light distribution pattern of a vehicle head light.

### DETAILED DESCRIPTION OF THE PREFERRED EMBODIMENTS

In the following, exemplary embodiments of the presently disclosed subject matter will be described with reference to the drawings. Although the presently disclosed subject matter will be described based on the following embodiments, the presently disclosed subject matter can be modified by various methods without departing from the scope of the presently disclosed subject matter, and thus it is possible to use embodiments other than the present embodiments. Accordingly, all possible changes within the scope of the presently disclosed subject matter are included in the scope of the claims.

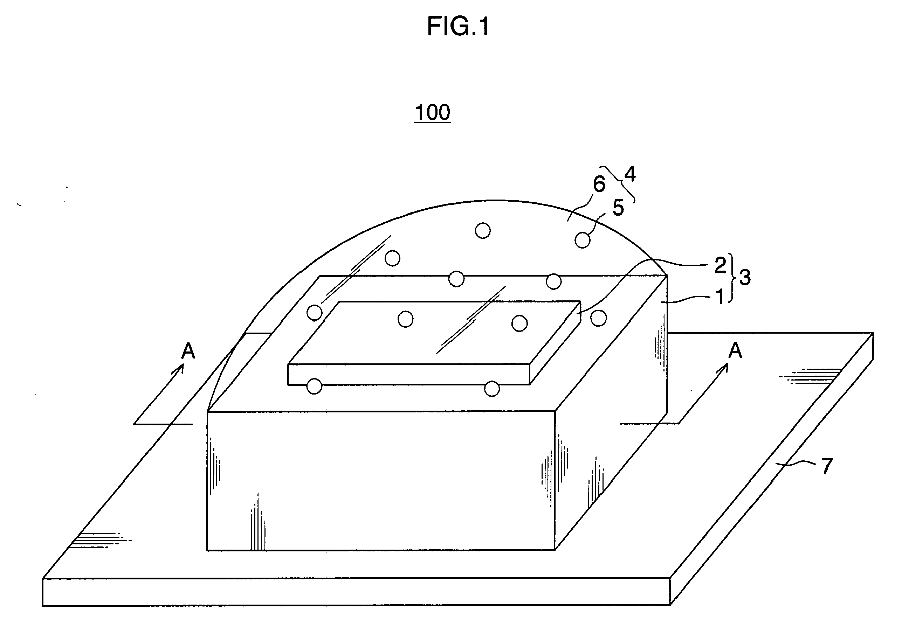

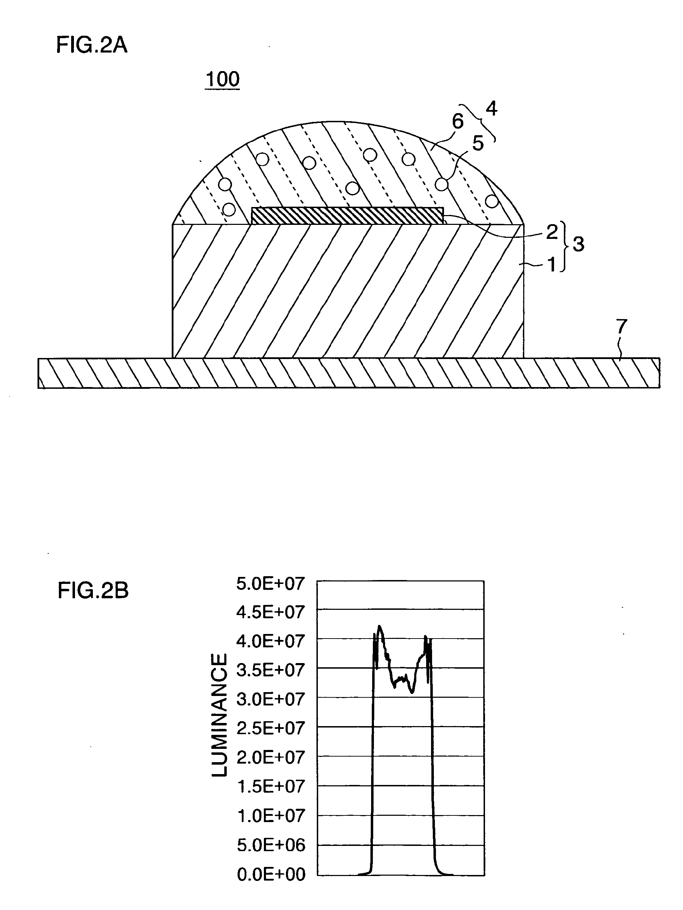

An embodiment of the presently disclosed subject matter will be described with reference to Figs. 1, 2A and 2B. Fig. 1 is a perspective view illustrating a semiconductor light emitting device 100. The semiconductor light emitting device 100 is provided with an element substrate 1, a semiconductor epitaxial layer 2 formed on the element substrate 1, and a resin layer 4 containing a fluorescent substance 5 which can include particles that are configured to wavelength-convert light from the semiconductor epitaxial layer 2. The resin layer 4 can be arranged on the element substrate 1 in a manner such that the side surfaces and an upper surface of the semiconductor epitaxial layer 2 are covered by the resin layer 4. A light emitting element 3 can be composed of the element substrate 1 and the semiconductor epitaxial layer 2 formed on the element substrate 1 and can define a light emitting portion.

In planar view, the semiconductor epitaxial layer 2 is smaller in area than the element substrate 1, and it is formed to fit in the element substrate 1. The resin layer 4 arranged on the element substrate 1 can cover not only the upper surface but also the side surfaces of the semiconductor epitaxial layer 2. The resin layer 4 can also be arranged on an upper surface of the element substrate 1 while not covering side surfaces of the element substrate 1.

The element substrate 1 can be composed of an opaque substrate that absorbs light from the light emitting portion of the semiconductor epitaxial layer 2 or, can be composed of a base substrate and a reflective film formed on the base substrate. Accordingly, the light from the light emitting portion of the semiconductor epitaxial layer 2 will not be transmitted through the element substrate 1.

In the resin layer 4, the fluorescent substance 5 which wavelength-converts part of the light (e.g. visible light and/or ultraviolet light) emitted from the semiconductor epitaxial layer 2 is dispersed in a highly heat-resistant transparent resin 6. As shown in Fig. 1, the resin layer 4 arranged on the element substrate 1 can be shaped with a circular top.

The resin layer 4 is formed by having a resin containing fluorescent substance 5 delivered into the light emitting element 3 by drops to harden thereafter, and the resin layer 4 formed in such way has a protuberant shape on the light emitting element 3. The resin layer 4 has a dome shape with a circular top of an approximately hemispherical shape, and a surface of the resin layer 4 is a curved surface connecting the top portion positioned at the upper center of the light emitting element 3 and respective sides of a rectangular upper surface of the element substrate 1.

Fig. 2A is a sectional view of the semiconductor light emitting device 100 taken along line 2A-2A in Fig. 1. At one cross section, the resin layer 4 has an inclined surface formed into an approximate arc inclining inwardly from the element substrate 1 toward the top. An apex of the resin layer 4 is positioned above a center point of the semiconductor epitaxial layer 2. As shown in Fig. 2A, the semiconductor light emitting device 100 can be mounted on a mounting substrate 7 or the like to be used as a semiconductor light emitting apparatus.

Fig. 2B shows a front luminance distribution of the semiconductor light emitting apparatus where the semiconductor light emitting device 100 is mounted on the mounting substrate 7. This exemplary semiconductor light emitting device 100 is provided with a resin layer 4, which is formed on a blue color light emitting element 3 including the semiconductor epitaxial layer 2 having an area of 950 µm by 950 µm formed on the element substrate 1 which has an area of 980 µm by 980 µm and a height of 0.1 mm, for example. The resin layer 4 can be formed by having a resin containing a fluorescent substance delivered into the light emitting element 3 by drops which are hardened thereafter. The external atmosphere surrounding the semiconductor light emitting device can be air. A maximum thickness of the resin layer 4 is 0.3 mm, in a sectional view shown in Fig. 2A, while a tangent line of the resin layer 4 drawn from a contact point of the element substrate 1, the resin layer 4 and the external atmosphere makes an angle of about 68 degree with the surface of the element substrate 1.

In the front luminance distribution of the semiconductor light emitting apparatus, a difference in front luminance at a boundary between a light emitting portion of the semiconductor light emitting device 100 and a light non-emitting portion of an exterior of the semiconductor light emitting device 100 can be relatively large. In other words, with respect to the front luminance distribution of the semiconductor light emitting apparatus, a difference in front luminance between the light emitting portion and the light non-emitting portion at an end portion of the semiconductor light emitting device 100 is large. In this case, the front luminance ratio of the light emitting portion to the light non-emitting portion could be brought to about 190:1. Here, the end portion of the semiconductor light emitting device 100 which is to be the light emitting portion is defined as an outer edge of the light emitting element, an outer edge of the element substrate or an outer edge of the resin layer, when viewed from above.

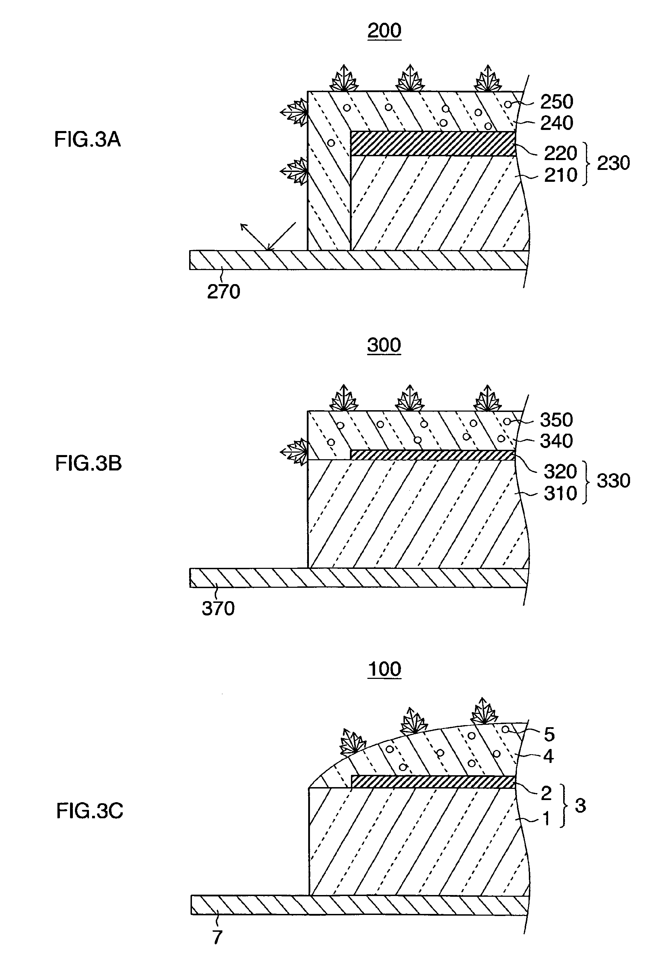

Next, a light emitting characteristic of a semiconductor light emitting device 100 made in accordance with principles of the presently disclosed subject matter will be described by comparing the semiconductor light emitting device 100 with a conventional semiconductor light emitting device, with reference to Figs. 3A to 3C. Fig. 3A illustrates one example of a conventional semiconductor light emitting device. A semiconductor light emitting device 200 is provided with a light emitting element 230, which is composed of a semiconductor epitaxial layer 220 being formed on a transparent element substrate 210 made of sapphire, etc., and a resin layer 240 containing fluorescent substance 250 which wavelength-convert light from the semiconductor epitaxial layer 220. The resin layer 240 is configured to cover side surfaces and an upper surface of the light emitting element 230. The semiconductor light emitting device 200 is mounted on a mounting substrate 270.

By driving the semiconductor light emitting device 200, light is emitted from the semiconductor epitaxial layer 220. A part of the light will be transmitted through the resin layer 240, while another part of the light will be wavelength-converted by the fluorescent substances 250 and then transmitted through the resin layer 240. As shown in Fig. 3A, in the semiconductor light emitting device 200, the light is emitted from an upper surface and side surfaces of the semiconductor epitaxial layer 220. The light from the semiconductor epitaxial layer 220 will be transmitted through the transparent element substrate 210, and similarly, a part of the light will be transmitted through the resin layer 240, while other parts of the light will be wavelength-converted by the fluorescent substance 250 and then transmitted through the resin layer 240. Thus, the light will be emitted from side surfaces of the semiconductor light emitting device 200, and light will thus not only be emitted in upper directions but also in a horizontal direction and lower directions from the semiconductor light emitting device 200. The light emitted in the lower direction will be reflected by the mounting substrate 270 towards an upper direction.

Therefore, when the front luminance distribution of the semiconductor light emitting device 200 is measured, the light from the semiconductor light emitting device 200 and the reflected light from the mounting substrate 270 will be included in the measurement. The front luminance distribution in this case will have a broad form at an end portion of the semiconductor light emitting device 200.

Fig. 3B illustrates another example of a conventional semiconductor light emitting device. A semiconductor light emitting device 300 is provided with a light emitting element 330, which is composed of a semiconductor epitaxial layer 320 formed on an opaque element substrate 310, and a resin layer 340 containing fluorescent substance 350 which wavelength-converts light from the semiconductor epitaxial layer 320. With respect to the semiconductor light emitting device 300, in planar view, the semiconductor epitaxial layer 320 is smaller in area than the opaque element substrate 310, and it is formed to fit in the element substrate 310. The resin layer 340 covers side surfaces and an upper surface of the semiconductor epitaxial layer 320. The semiconductor light emitting device 300 is mounted on a mounting substrate 370.

By driving the semiconductor light emitting device 300, light is emitted from the semiconductor epitaxial layer 320. A part of the light will be transmitted through the resin layer 340, while other parts of the light will be wavelength-converted by the fluorescent substance 350 and will then be transmitted through the resin layer 340. The light from the semiconductor epitaxial layer 320 will be emitted in the upper surface and side surface directions. On the other hand, since light from the semiconductor epitaxial layer 320 will not be transmitted through the opaque element substrate 310, no light will be emitted from side surfaces of the opaque element substrate 310.

However, as shown in Fig. 3B, in the semiconductor light emitting device 300, the light that is emitted from side surfaces of the semiconductor epitaxial layer 320 will be emitted from side surfaces of the resin layer 340, and will be emitted in horizontal and lower directions. In this case, the light emitted in the lower direction will be reflected by the mounting substrate 370 towards an upper direction.

Therefore, when the front luminance distribution of the semiconductor light emitting device 300 is measured, the light from the semiconductor light emitting device 300 and the reflected light from the mounting substrate 370 will be measured at an end portion of the semiconductor light emitting device 300. The front luminance distribution in this case will have a broad form at an end portion of the semiconductor light emitting device 300.

Fig. 3C is a sectional view of the semiconductor light emitting device 100 according to the presently disclosed subject matter. Same reference numerals will be used for components similar to those in the semiconductor light emitting device 100 shown in Fig. 1 or Fig. 2A, and there might be cases where descriptions on such redundant components will be omitted for brevity.

By driving the semiconductor light emitting device 100, light will be emitted from the semiconductor epitaxial layer 2. A part of the light will be transmitted through the resin layer 4, while other parts of the light will be wavelength-converted by the fluorescent substance 5 and then transmitted through the resin layer 4. The light from the semiconductor epitaxial layer 2 will be emitted in upper surface and side surface directions. On the other hand, since the light from the semiconductor epitaxial layer 2 will not be transmitted through the opaque element substrate 1, no light will be emitted from side surfaces of the element substrate 1.

As shown in Fig. 3C, the light emitted from side surfaces of the semiconductor epitaxial layer 2 will be led in an upper direction when passing through the resin layer 4. Therefore, light rays emitted in directions lower than a horizontal direction will be reduced to a considerable extent as compared to the conventional cases shown in Figs. 3A and 3B, whereby light reflected by the mounting substrate 7 will also be reduced. As a result, it is possible to achieve a semiconductor light emitting device 100 having a front luminance distribution where there is a large difference in front luminance between the light emitting portion and the light non-emitting portion at the end portion of the semiconductor light emitting device 100.

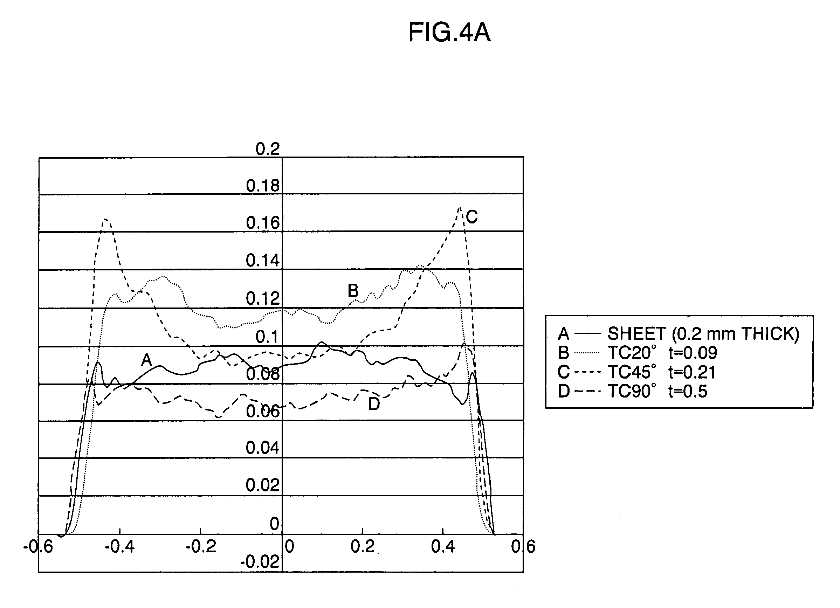

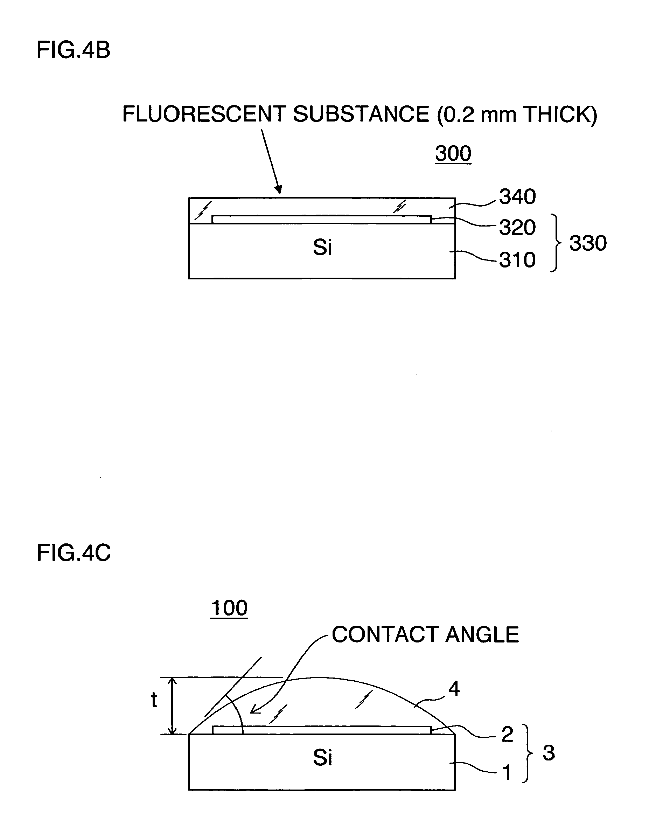

Fig. 4A is a diagram representing simulation results of front luminance distributions between the semiconductor light emitting device 100 and the conventional semiconductor light emitting device 300 used as a comparison example. Figs. 4B and 4C are schematic diagrams showing the conditions present when the simulation shown in Fig. 4A is performed. In this embodiment of the disclosed subject matter, the semiconductor light emitting device 100 is provided with a light emitting element 3 which is composed of an element substrate 1 having a silicon substrate and a reflective layer arranged on the silicon substrate, and a semiconductor epitaxial layer 2 formed on the element substrate 1. A resin layer 4 containing fluorescent substance (not shown) is arranged on the light emitting element 3 and has a circular top. In different test examples of the semiconductor light emitting device 100, an angle (hereinafter referred to as a contact angle) on the side of the resin layer 4 formed between a tangent line of the resin layer 4, drawn from a contact point of the element substrate 1, the resin layer 4 and the external atmosphere, and the surface of the element substrate 1 is provided with the following values: 20 degrees; 45 degrees; and 90 degrees. Along with the changes in the contact angle, a height "t" of the resin layer 4 up to its apex is provided with the following values; 0.09 mm (20 degrees); 0.21 mm (45 degrees); and 0.50 mm (90 degrees).

On the other hand, the semiconductor light emitting device 300 is provided with a light emitting element 330 which is composed of an element substrate 310 composed of the same kind of silicon substrate as that of the semiconductor light emitting device 100, and a reflective layer arranged on the silicon substrate, and a semiconductor epitaxial layer 320. A resin layer 340 contains fluorescent substance (not shown) and is formed as a sheet with a predetermined thickness (0.2 mm).

In the graph shown in Fig. 4A, reference character A designates a front luminance distribution in the comparison example, whereas reference characters B to D designate front luminance distributions for the above described embodiments of the disclosed subject matter having various contact angles and heights "t". Reference character A represents a front luminance distribution of the semiconductor light emitting device 300. In the front luminance distribution A, the front luminance exhibits a maximum value at a center portion. In the front luminance distribution, the front luminance decreases gradually from the maximum value at the center portion toward both ends of the semiconductor light emitting device 300. At points passing both end portions, the front luminance decreases almost perpendicularly.

Reference character B represents a front luminance distribution of a semiconductor light emitting device 100 according to the presently disclosed subject matter where the resin layer 4 has a contact angle of 20 degrees and a height of 0.09 mm. In the front luminance distribution B, the front luminance exhibits a minimum value at a center portion, and the front luminance increases from the center portion toward both ends of the semiconductor light emitting device 100. At points passing both end portions, the front luminance decreases almost perpendicularly.

Reference character C represents a front luminance distribution of a semiconductor light emitting device 100 according to the presently disclosed subject matter where the resin layer 4 has a contact angle of 45 degrees and a height of 0.21 mm. In the front luminance distribution C, the front luminance exhibits a minimum value at a center portion, and the front luminance is increasing drastically from the center portion toward both ends of the semiconductor light emitting device 100. At points passing both end portions, the front luminance decreases almost perpendicularly.

Reference character D represents a front luminance distribution of a semiconductor light emitting device 100 according to the presently disclosed subject matter where the resin layer 4 has a contact angle of 90 degrees and a height of 0.50 mm. In the front luminance distribution D, the front luminance exhibits a minimum value at a center portion, and the front luminance is increasing gradually from the center portion toward both ends of the semiconductor light emitting device 100. At points passing both end portions, the front luminance decreases almost perpendicularly.

As can be seen in the front luminance distribution graph of Fig. 4A, in any of the front luminance distributions B to D, the front luminance distribution exhibits the minimum value of front luminance at the center portion, whereas it exhibits the maximum value of front luminance at the end portion. Therefore, the front luminance distribution exhibits a precipitous form at the end portions, which is different from the case of luminance characteristics for the comparison example.

Particularly, among the front luminance distributions B to D, the front luminance distribution C where the contact angle is 45 degrees exhibits the largest maximum value of front luminance at the end portion. Moreover, the front luminance distribution C exhibits the largest difference in front luminance between the end portion and the center portion. Comparing the front luminance distribution B and the front luminance distribution D, the front luminance distribution B exhibits a larger value of front luminance at the end portion than does the front luminance distribution D. With respect to a difference in front luminance between the end portion and the center portion, there is not much difference between the front luminance distributions B and D.

With respect to a semiconductor light emitting device that is to be used in a lighting device, the semiconductor light emitting device typically has a front luminance distribution exhibiting a maximum value of front luminance at an end portion. In a case when the semiconductor light emitting device has a front luminance distribution exhibiting a maximum value of front luminance at a center portion, a difference in front luminance at a boundary between a light emitting portion and a light non-emitting portion becomes small, whereby a precipitous front luminance distribution cannot be achieved. In other words, a clear cutoff line for the light distribution is not achieved. In a lighting device, an optical device such as a lens, etc. can be arranged on an upper side of the semiconductor light emitting device. By using the optical device, it is possible to change the front luminance distribution of the semiconductor light emitting device.

However, with a semiconductor light emitting device which does not have a front luminance distribution exhibiting a maximum value of front luminance at an end portion, it is not possible to improve the front luminance at the end portion even when an optical device is arranged thereon.

On the other hand, in accordance with the above-described embodiments of semiconductor light emitting devices made in accordance with principles of the presently disclosed subject matter, the front luminance distribution exhibits a maximum value of front luminance at the end portion. Accordingly, it is possible to achieve a desired front luminance distribution by using an optical device.

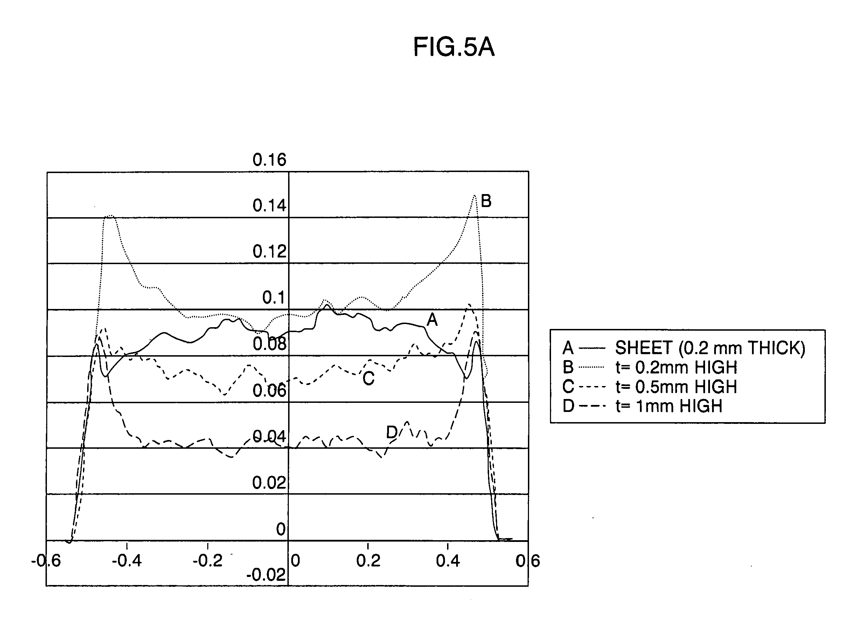

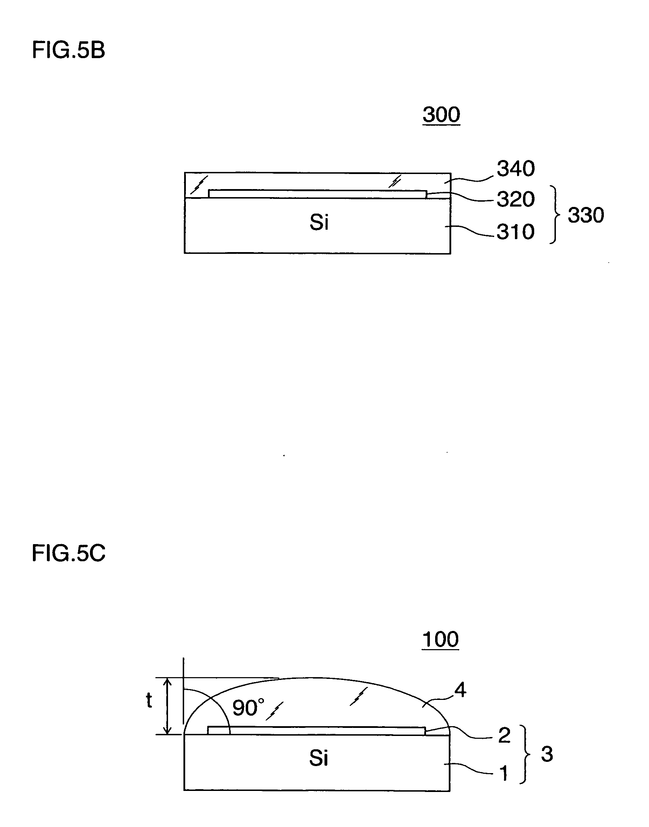

Fig. 5A is a diagram representing simulation results of front luminance distributions between the semiconductor light emitting device 100 and the conventional semiconductor light emitting device 300. Figs. 5B and 5C are schematic diagrams showing the conditions when the simulation shown in Fig. 5A was performed. Structures of the semiconductor light emitting device 100 and the conventional semiconductor light emitting device 300 are the same as the ones described above with respect to Fig. 4A-C. However, in the semiconductor light emitting device 100, a contact angle on the side of the resin layer 4 formed between a tangent line of the resin layer 4, drawn from a contact point of the element substrate 1, the resin layer 4 and the external atmosphere, and the surface of the element substrate 1 is to be 90 degrees, while a height "t" of the resin layer 4 is to be changed to 0.2 mm, 0.5 mm and 1.0 mm.

In the graph shown in Fig. 5A, reference character A designates a front luminance distribution for the comparison example, whereas reference characters B to D designate front luminance distributions for various embodiments of the presently disclosed subject matter. Reference character A represents a front luminance distribution of the semiconductor light emitting device 300. In the front luminance distribution A, the front luminance exhibits a maximum value at a center portion. In the front luminance distribution, the front luminance decreases gradually from the maximum value at the center portion toward both ends of the semiconductor light emitting device 300. At points passing both end portions, the front luminance decreases almost perpendicularly.

Reference character B represents a front luminance distribution of the semiconductor light emitting device 100 in which the resin layer 4 has a height of 0.2 mm. In the front luminance distribution B, the front luminance exhibits a minimum value at a center portion, and the front luminance increases from the center portion toward both ends of the semiconductor light emitting device 100. At points passing both end portions, the front luminance decreases almost perpendicularly.

Reference character C represents a front luminance distribution of a semiconductor light emitting device 100 where the resin layer 4 has a height of 0.5 mm. In the front luminance distribution C, the front luminance exhibits a minimum value at a center portion, and the front luminance increases drastically from the center portion toward both ends of the semiconductor light emitting device 100. At points passing both end portions, the front luminance decreases almost perpendicularly.

Reference character D represents a front luminance distribution of the semiconductor light emitting device 100 where the resin layer 4 has a height of 1.0 mm. In the front luminance distribution D, the front luminance exhibits a minimum value at a center portion, and the front luminance increases gradually from the center portion toward both ends of the semiconductor light emitting device 100. At points passing both end portions, the front luminance decreases almost perpendicularly.

As can be seen in the front luminance distribution graph shown in Fig. 5A, in the front luminance distributions B to D, the front luminance distribution exhibits the minimum value of front luminance at the center portion, whereas it exhibits the maximum value of front luminance at the end portion. Thus, the front luminance distribution exhibits a precipitous form at the end portion, which is different from the case of the comparison example.

Particularly, among the front luminance distributions B to D, the front luminance distribution B where the height of the resin layer is 0.2 mm exhibits the largest maximum value of front luminance at the end portion. Moreover, the front luminance distribution B exhibits the largest difference in front luminance between the end portion and the center portion. Comparing the front luminance distribution C and the front luminance distribution D, the front luminance distribution C exhibits a slightly larger value of front luminance at the end portion than does the front luminance distribution D. With respect to a difference in front luminance between the end portion and the center portion, the front luminance distribution D shows a larger value than the front luminance distribution C.

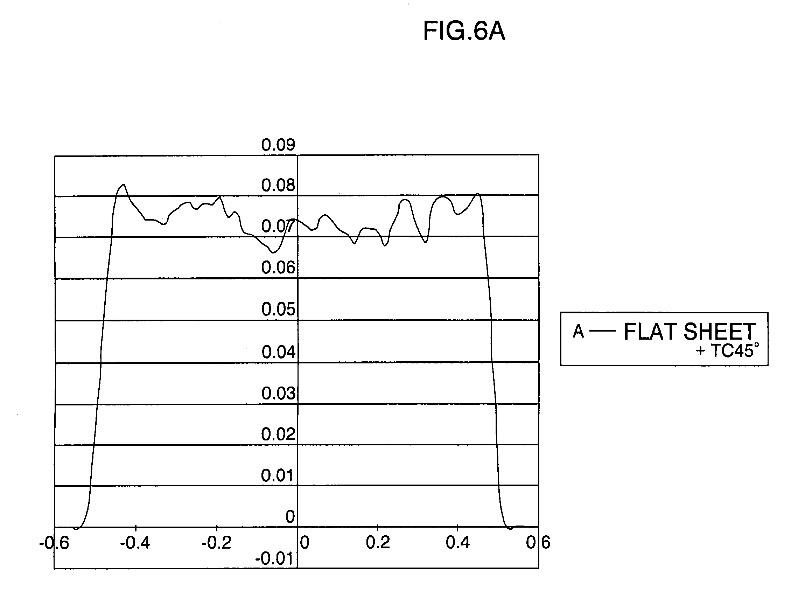

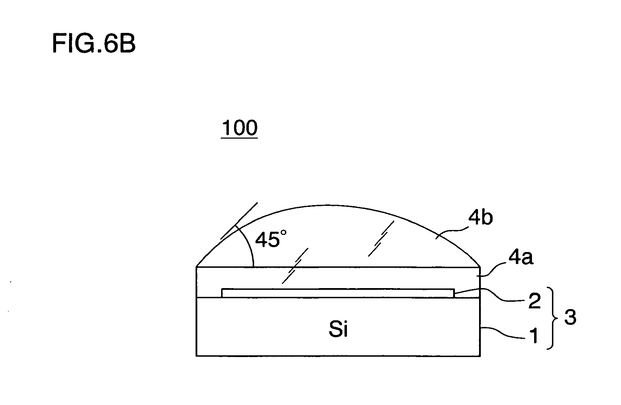

Fig. 6A is a diagram representing a simulation result of a front luminance distribution of a semiconductor light emitting device 100. Fig. 6B is a schematic diagram showing conditions when the simulation shown in Fig. 6A is performed. The semiconductor light emitting device 100 includes a light emitting element 3 composed of an element substrate 1 made of silicon and a semiconductor epitaxial layer 2 formed on the element substrate 1. A sheet-like resin layer 4a is formed on the light emitting element 3 with a predetermined thickness (0.2 mm). A dome-shaped resin layer 4b is formed on the sheet-like resin layer 4a. Both of the sheet-like resin layer 4a and the dome-shaped resin layer 4b include fluorescent substance.

In the semiconductor light emitting device 100 of Fig. 6A, an angle (a contact angle) on the side of the resin layer 4b formed between a tangent line of the resin layer 4b, drawn from a contact point of the sheet-like resin layer 4a and the dome-shaped resin layer 4b, and the surface of the element substrate 1 is 45 degrees.

As shown in the graph shown in Fig. 6A, the front luminance distribution of the semiconductor light emitting device 100 provided with the sheet-like resin layer 4a and the dome-shaped resin layer 4b exhibits maximum values of front luminance at both end portions and a minimum value of front luminance at a center portion. Meanwhile, a difference between the maximum value and the minimum value is small, and the front luminance distribution shows a generally flat form. At points passing both end portions, the front luminance decreases almost perpendicularly.

Even in the case when the sheet-like resin layer 4a is formed on the light emitting element 3, the front luminance distribution can be improved by arranging the dome-shaped resin layer 4b on the sheet-like resin layer 4a. In other words, a resin layer with slopes in the uppermost layer can tolerate the arrangement of a sheet-like resin layer as a part of the resin layer. Thus, even when the resin layer has side surfaces perpendicular to the surface of the element substrate, it may be acceptable as long as the part of the resin layer having such side surfaces has a thickness within a predetermined range. By combining the resin layer 4a having side surfaces perpendicular to the surface of the element substrate with the dome-shaped resin layer 4b, it is possible to easily obtain a desired front luminance distribution.

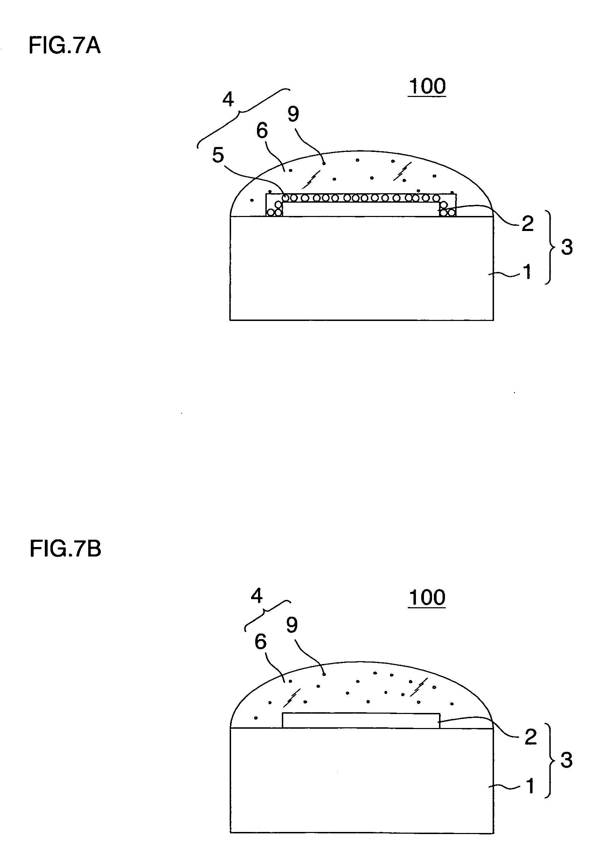

Next, different exemplary combinations of a light emitting element and a resin layer which can be used in the semiconductor light emitting device according to the presently disclosed subject matter will be described with reference to Figs. 7A and 7B.

The semiconductor light emitting device 100 can include an element substrate composed of a transparent semiconductor substrate and a reflective layer formed on the transparent semiconductor substrate. The reflective layer can be a metal, or a so-called DBR can be used. A reflectance ratio of the reflective layer should be 90% or over.

The resin layer 4 should be adequate as long as it is inclined to the inward side of the semiconductor light emitting device 100 toward the top. By forming the resin layer 4 in an inclined manner and in a form of an approximate arc, it is possible to achieve a semiconductor light emitting device 100 that has few extreme highs and lows in luminance within its light distribution pattern. On the other hand, if the resin layer 4 has an angular cross section, the semiconductor light emitting device 100 may have distinct highs and lows in luminance within its light distribution pattern. The resin layer 4 is not limited to having a dome shape with a circular top or being inclined as a whole. By contrast, it could also have an approximately flat portion at its apex, for example. With respect to the present description, such a form will be referred to as a dome shape.

The semiconductor light emitting device 100 shown in Fig. 7A is provided with a light emitting element 3 composed of an opaque element substrate 1 and a semiconductor epitaxial layer 2 formed on the element substrate 1. A resin layer 4 is composed of a fluorescent body containing layer containing fluorescent substance 5 and a scattering material containing layer containing scattering material 9. Since the resin layer 4 is a laminated body including the scattering material containing layer and the fluorescent body containing layer, it is possible to obtain a desired light emitting characteristic and emission color by adjusting thickness and content rate with respect to each layer.

The semiconductor light emitting device 100 shown in Fig. 7B includes a light emitting element 3 composed of an opaque element substrate 1 and a semiconductor epitaxial layer 2 formed on the element substrate 1. A resin layer 4 is composed of a transparent resin 6 and scattering material 9. Since the resin layer 4 has a shape with a circuit top, it is possible to obtain a front luminance distribution exhibiting precipitous rise in front luminance at the end portion, as described above.

The semiconductor epitaxial layer in this present embodiment is composed of a GaN-based compound semiconductor, for instance, and will emit light in bandwidth ranging from ultraviolet to green. The fluorescent substance can include a YAG-based fluorescent substance or other suitable wavelength conversion material which is configured to wave-length convert blue light into yellow colored light when the wavelength conversion material is excited by the blue colored light. The scattering material can include barium oxide or barium titanate or other suitable material. The materials for each of the above-described components are not limited to those just mentioned, but could include other materials commonly known in the art.

The combination of the light emitting element and the resin layer which are applicable to the semiconductor light emitting device according to the presently disclosed subject matter have been described with reference to Figs. 7A and 7B. However, the semiconductor light emitting device according to the presently disclosed subject matter is not limited to those examples. In particular the light emitting element and the resin layer can be paired in various manners and used in the semiconductor light emitting device according to the presently disclosed subject matter.

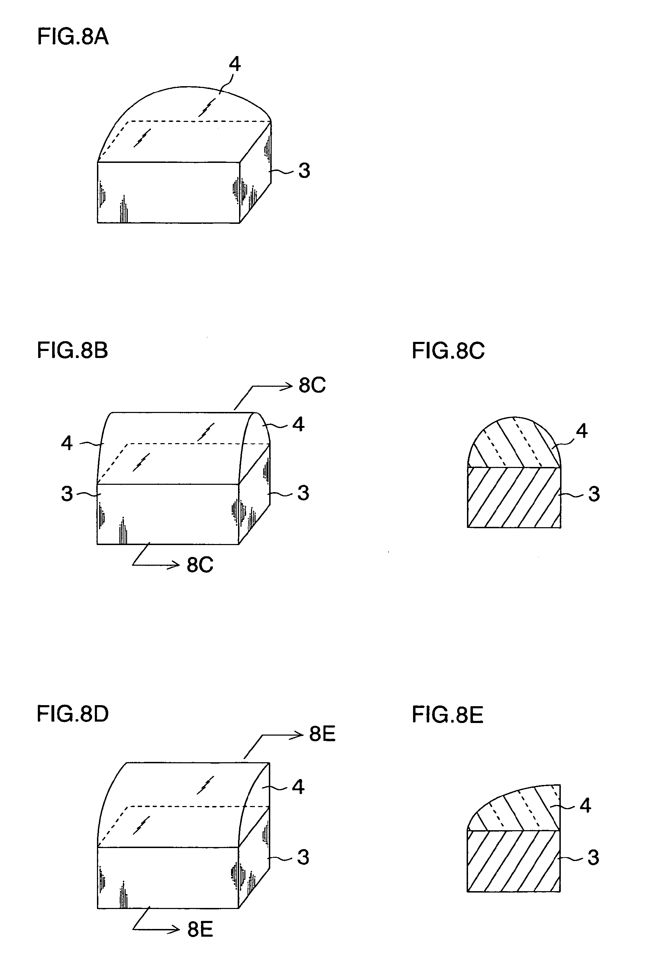

Exemplary forms of a resin layer which could be used in the semiconductor light emitting device according to the presently disclosed subject matter will be described with reference to Figs. 8A to 8E. In Figs. 8A to 8E, only the resin layer 4 and the light emitting element are shown while the element substrate, the semiconductor epitaxial layer, the fluorescent substances, etc., are omitted from view.

The semiconductor light emitting device 100 in Fig. 8A has a resin layer 4 of an approximately hemispherical shape provided on light emitting element 3. The shape of the resin layer 4 is obtained by applying a resin that includes dispersed scattering material and/or fluorescent substance by potting, and letting the resin harden thereafter. Thus, the resin layer 4 is formed with an arc shape in the upper surface at a central cross section. The shape of the resin layer 4 can be changed by controlling viscosity and thixotropy of the resin that is to be applied by the potting process. For instance, a curvature, a distance from an end portion of the element substrate to the resin layer, a contact angle of the resin layer, a height of the resin layer, etc., can be changed.

By forming the resin layer 4 into a dome shape, it is possible to obtain a front luminance distribution that is precipitous at end portions of all four sides of the light emitting element 3.

Since the resin layer 4 is formed by applying a resin by potting, the resin layer 4 can be easily formed into a dome shape.

The semiconductor light emitting device 100 in Fig. 8B has a resin layer 4 of an approximately semi-cylindrical shape provided on a light emitting element 3. Fig. 8C is a sectional view of the semiconductor light emitting device shown in Fig. 8B taken along line 8C-8C of Fig. 8B. The shape of the resin layer 4 is obtained by molding a resin including dispersed scattering material and/or fluorescent substance into a desired shape. In the semiconductor light emitting device 100 in Fig. 8B, a cross section taken along line 8C-8C has a semicircular shape (as shown in Fig. 8C). With respect to this cross sectional shape, the semiconductor light emitting device 100 can have a front luminance distribution in which there is a large difference in front luminance between a light emitting portion and a light non-emitting portion at both end portions of the semiconductor light emitting device 100.

On the other hand, although it is not shown, a cross section of the device 100 that is taken perpendicular to the line 8C-8C will be an approximately rectangular shape. With respect to this cross sectional shape, a front luminance distribution will exhibit a maximum value of front luminance at a center portion, as in the case of the conventional semiconductor light emitting device. Accordingly, the semiconductor light emitting device 100 in Fig. 8B will have a front luminance distribution that is precipitous at end portions of the two longest facing sides of the light emitting element 3.

Depending on the characteristics that are required in a lighting device, there are cases in which a front luminance distribution which is precipitous at end portions of all four sides of the light emitting element 3 is not required.

The semiconductor light emitting device 100 in Fig. 8D has a resin layer 4 provided on a light emitting element 3. Fig. 8E is a sectional view of the semiconductor light emitting device shown in Fig. 8D taken along line 8E-8E of Fig. 8D. A shape of the resin layer 4 is obtained by molding a resin including dispersed scattering material and/or fluorescent substance into a desired shape. In the semiconductor light emitting device 100 in Fig. 8D, a cross section taken along line 8E-8E has a shape of an arc extending from one end to the other end (shown in Fig. 8E). The resin layer 4 is inclined inwardly toward the top so that its apex will be positioned at the edge of the other end. With respect to the cross section taken along line 8E-8E, the semiconductor light emitting device 100 exhibits a front luminance distribution which is precipitous at one end only.

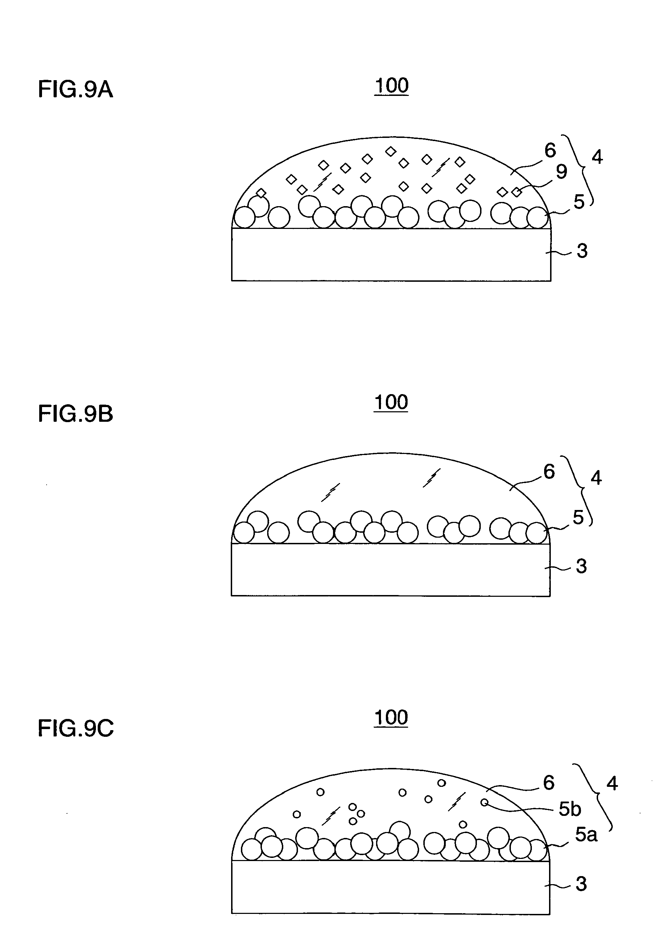

Next, exemplary distributions of scattering material and fluorescent substance in the resin layer in consideration of heat dissipation effect will be described with reference to Figs. 9A to 9C. Same reference numerals will be used for components similar to those already described, and descriptions on such redundant components will be omitted for brevity. In addition, there might be cases in which such components will be omitted where necessary or desired.

The semiconductor light emitting device 100 shown in Fig. 9A includes a light emitting element 3 and a resin layer 4 composed of a transparent resin 6 containing fluorescent substance 5 and scattering material 9. The light emitting element 3 is mounted on a mounting board (not shown). In the present embodiment, since the light emitting element 3 and the resin layer 4 do not have their circumference directly covered with a sealing resin, the resin layer 4 is surrounded by air. Meanwhile in other embodiments, there are cases in which the light emitting element 3 and the resin layer 4 are covered with a transparent cap or the like. Or, in other embodiments, the light emitting element 3 and the resin layer 4 might be surrounded by gas such as nitrogen or the like.

All or almost all of the fluorescent substance 5 in the resin layer 4 is deposited on the light emitting element 3, or those particles of the fluorescent substance 5 which are not deposited directly on the light emitting element 3 can settle such that they are nearly contacting the fluorescent substance 5 deposited on the light emitting element 3 or nearly contacting the fluorescent substance 5 contacting the light emitting element 3. This means that most of the fluorescent substance 5 in the resin layer 4 is thermally connected with the light emitting element 3 either directly or indirectly.

Since the fluorescent substance 5 and the light emitting element 3 are thermally connected, the heat generated by the fluorescent substance 5 will be transmitted to the light emitting element 3 without being passed on to the transparent resin 6 which has a low thermal conductivity (for instance, if the transparent resin is silicon, the thermal conductivity will be about 0.2 W/mK).

The thickness of the layer formed by the deposited fluorescent substance 5 can be changed arbitrarily by changing the kind and the amount of the fluorescent substance 5. In a case in which YAG: Ce is used as the fluorescent substance, for instance, as long as the thickness of the layer of the fluorescent substance 5 is 50 µm or less, desired white light can be obtained while the heat from the fluorescent substance 5 can be transmitted to the light emitting element 3. By having the scattering material 9 contained in the resin layer 4, it is possible to reduce unevenness of color.

Different from Fig. 9A, a resin layer 4 in the semiconductor light emitting device 100 shown in Fig. 9B does not include scattering material. As in the case of Fig. 9A, all or almost all of the fluorescent substance 5 in the resin layer 4 is deposited on the light emitting element 3, and that fluorescent substance 5 which is not deposited directly on the light emitting element 3 settles such that it nearly contacts the fluorescent substance 5 deposited on the light emitting element 3 or nearly contacts the fluorescent substance 5 contacting the light emitting element 3. This means that most of the fluorescent substance 5 in the resin layer 4 is thermally connected with the light emitting element 3 either directly or indirectly. Although the semiconductor light emitting device 100 in Fig. 9B is not provided with scattering material, scattering material is not an indispensable constituent feature in terms of improving heat dissipation of the fluorescent substance 5.

Fig. 9C shows the semiconductor light emitting device 100 as having a resin layer 4 containing fluorescent substance 5a and fluorescent substance 5b, and fluorescent substance 5b includes particles having a smaller particle size than a particle size of particles that make up the fluorescent substance 5a. The smaller particle size fluorescent substance 5b is hard to deposit as compared to the relatively large particle size fluorescent substance 5a. For instance, in a case of forming the resin layer 4 by applying a resin containing the fluorescent substance 5a and the smaller particle size fluorescent substance 5b by potting on the light emitting element 3 and letting the resin thermally harden, the smaller particle size fluorescent substance 5b can be easily dispersed within the resin layer 4.

The smaller particle size fluorescent substance 5b has less conversion efficiency than the large particle size fluorescent substance 5a. However, the smaller particle size fluorescent substance 5b makes it possible to reduce unevenness of color. The resin layer can further contain scattering materials.

On the other hand, when the amount of small particle size fluorescent substance 5b is too large, it will be disadvantageous in terms of heat dissipation. Therefore, the amount of the fluorescent substance 5b should be less than the amount of the deposited fluorescent substance 5 a.

Since the semiconductor light emitting device in each of Figs. 9A to 9C has a resin layer 4 with a circular top, the semiconductor light emitting device can have a front luminance distribution that is precipitous at the end portion, regardless of the state of distribution of the fluorescent substance 5.

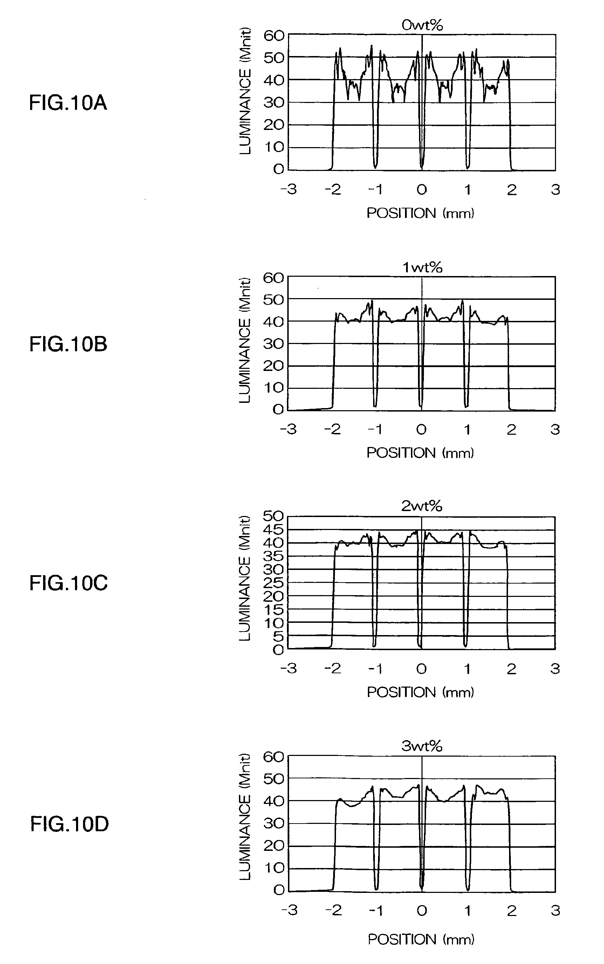

Figs. 10A to 10D illustrate front luminance distributions of the semiconductor device where the fluorescent substance is deposited within the resin layer and thermally connected with the light emitting element. In any of the cases shown in Figs. 10A to 10D, the front luminance distribution is measured under the condition that four of the semiconductor light emitting devices are arranged in a line, while each of the semiconductor light emitting devices has a dome-shaped resin layer with a circular top, as described with reference to the device shown in Figs. 1, 2A and 2B. Fig. 10A shows a front luminance distribution of the semiconductor light emitting device where the resin layer contains no scattering material (0 wt%) in the resin layer. Fig. 10B shows a front luminance distribution of the semiconductor light emitting device where the resin layer contains scattering materials at a ratio of 1 wt%. Fig. 10C shows a front luminance distribution of the semiconductor light emitting device where the resin layer contains scattering materials at a ratio of 2 wt%. Fig. 10D shows a front luminance distribution of the semiconductor light emitting device where the resin layer contains scattering materials at a ratio of 3 wt%. In any of these cases, the semiconductor light emitting device can have a front luminance distribution that is precipitous at end portions thereof.

By changing the amount of scattering material, a difference in front luminance between an end portion and a center portion with respect to the front luminance distribution can be controlled. The front luminance distribution of the semiconductor light emitting device can be turned into a desired pattern in compliance with the optical characteristic that is required in a lighting device.

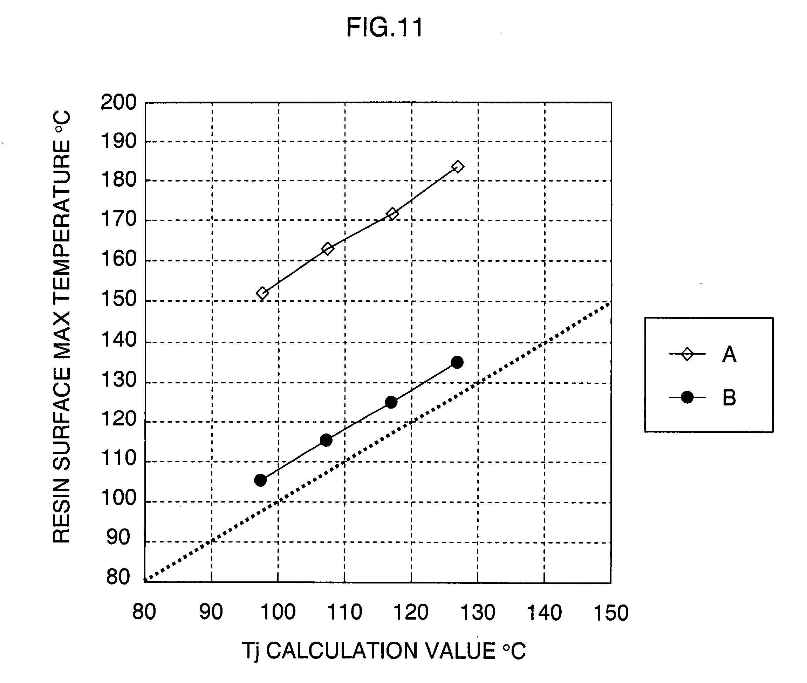

Fig. 11 is a graphic representation comparing measurement results on resin surface maximum temperatures and Tj calculation values between a case in which the fluorescent substance 5 is dispersed within the resin layer and a case in which the fluorescent substance 5 is deposited within the resin layer. Surface temperatures of the layers of fluorescent substance are measured by an infrared (IR) camera.

Reference character A represents measurement results with respect to the semiconductor light emitting device having the resin layer formed only on the light emitting element while YAG fluorescent substance is dispersed evenly within the resin layer. Reference character B represents measurement results with respect to the semiconductor light emitting device having the resin layer formed only on the light emitting element while YAG fluorescent substance is deposited within the resin layer.

In the graph of Fig. 11, the X axis shows Tj calculation values (°C) at the time when the light emitting element is driven. The Tj calculation value indicates a temperature of the light emitting element. In deriving the Tj calculation value, an expression "Tj (°C) = Rth (°C/W) - If (A) . Vf (V) + Ta (°C)" is used. Here, "Rth" designates thermal resistance of the semiconductor light emitting device and a heat sink. "If" and "Vf" designate a current and a voltage at the time when the light emitting element is driven, respectively. "Ta" designates an atmosphere temperature.

The Y axis shows temperatures of the resin layer surface measured by the IR camera. In the cases of measurement results A and B, the light emitting element is driven at a power density of approximately 2.5 (W/mm²). Furthermore, a Tj value is varied according to changes in the atmosphere temperature.

In the measurement result A, a resin layer surface temperature measured by the IR camera is considerably high with respect to a light emitting element temperature Tj. A difference between the two is over 50°C. For instance, when Tj is 120°C, the surface temperature of the layer of fluorescent substances is measured as about 175°C. This indicates that the amount of transparent resin is small with respect to the amount of fluorescent substance, and thus the transparent resin in the resin layer is raised to a high temperature due to the heat generated by the fluorescent substance.

At this time, a light flux with respect to the semiconductor light emitting device in the case of measurement result A is being decreased to a considerable extent. This result indicates that heat is being accumulated in high concentration per unit volume and heat dissipation with respect to such heat is not being done sufficiently due to the condition that the resin layer is arranged only on the light emitting element. When the semiconductor light emitting device in this case, where heat dissipation is insufficient, is continuously energized for a long period of time, such as over 1000 hours, a part of the transparent resin might volatilize to cause reduction in volume of the transparent resin, or the transparent resin itself might blacken. Therefore, there is a possibility that the semiconductor light emitting device will have its performance deteriorate to a considerable extent considering the heat dissipation characteristic.

In the semiconductor light emitting device with respect to the case of measurement result B, where the fluorescent substance is deposited within the resin layer, there is little difference between the Tj value and the surface temperature of the layer of fluorescent substances, as the difference between the two is measured as less than 10°C. This is because all or almost all of the fluorescent substance in the resin layer is deposited on the light emitting element, or those particles of the fluorescent substance which are not deposited directly on the light emitting element are settled in a way contacting the fluorescent substance deposited on the light emitting element or in a way contacting the fluorescent substance contacting the light emitting element, whereby heat dissipation is made possible as the heat generated by the fluorescent substance is transmitted to the light emitting element mostly without being passed on to the transparent resin which has a low thermal conductivity.

In the case of Fig. 11, although the Tj value is varied by changing the atmosphere temperature, the same kinds of effect can be obtained in a case of having the Tj value varied by increasing the driving current of the light emitting element.

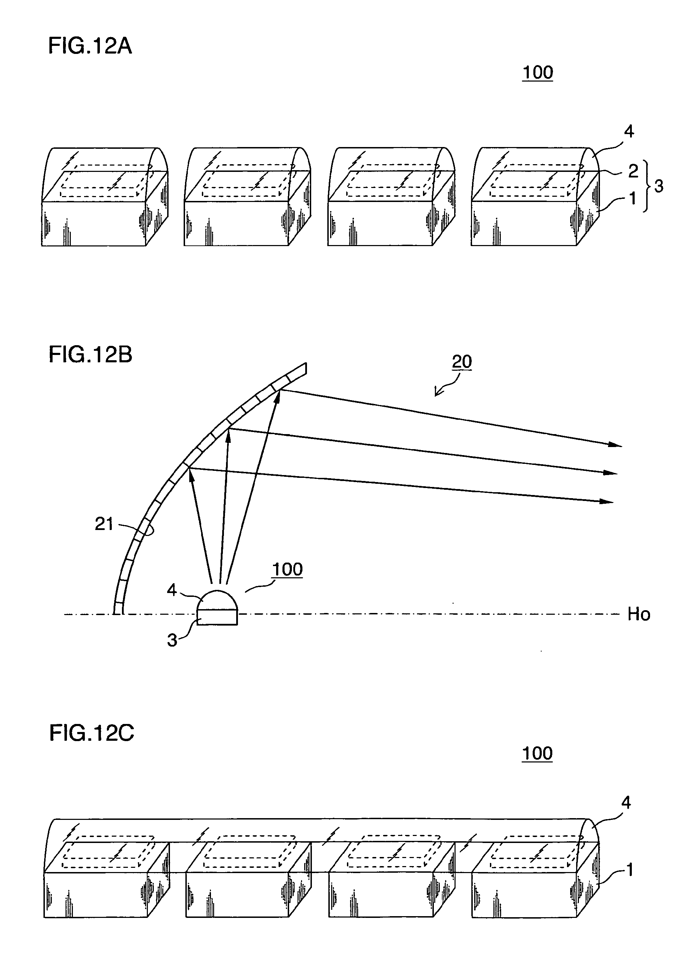

Next a vehicle lamp adopting the semiconductor light emitting device as described above will be described with reference to Figs. 12A to 12C. As shown in Fig. 12A, in the vehicle lamp according to the present embodiment, a semiconductor light emitting apparatus having four of the semiconductor light emitting devices 100, each of which being provided with the resin layer 4 of an approximately semi-cylindrical shape on the light emitting elements 3, and arranged in a line, is used as a light source. Each of the light emitting elements 3 in the present embodiment has a rectangular shape in top planar view, and they are arranged such that their long sides will make a straight line.

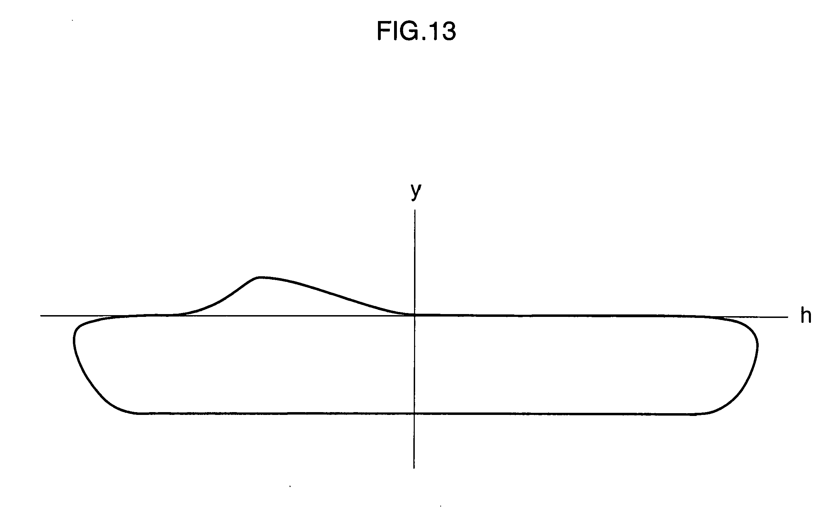

Fig. 12B shows an example of a state in which the semiconductor light emitting devices 100 are set in a head light 20 which includes a reflector 21 of a paraboloid of revolution form. The plurality of semiconductor light emitting devices 100 are arranged linearly in a direction perpendicular to a center line Ho (i.e. an optical axis of the head light 20) in a horizontal direction with respect to reflector 21. In a case of irradiating an upper half portion of the reflector 21, the plurality of semiconductor light emitting devices 100 should be positioned in the vicinity of a focal point of the paraboloid of revolution including the position of the focal point (for example, at a position arbitrarily a head of the focal point). As the reflector 21 reflects the light, a light distribution pattern, as shown in Fig. 13, which is suitable for a low beam light distribution for irradiating an area below a horizontal line H can be obtained depending on a shape of a light emitting portion of the semiconductor light emitting device.

In other words, by adopting the semiconductor light emitting apparatus using the semiconductor light emitting devices as a light source for a vehicle head light, it is possible to have a light distribution pattern where a horizontal line with a sharp light-dark boundary can be formed, and thus the optical design can be made simple. Furthermore, since the lighting intensity of an edge area forming the horizontal line can be raised, it is possible to have improved distance visibility. In the semiconductor light emitting apparatus serving as the light source for the vehicle head light, when a plurality of light emitting devices are to be arranged as shown in Fig. 12A, each resin layer 4 will have a portion that inclines inwardly toward the top at a cross section perpendicular to a longitudinal direction of the elements arrangement (and perpendicular to each longitudinal axis of each light emitting device). Then as shown in Fig. 12B, the resin layer will have a portion that inclines inwardly toward the top at a cross section along a lighting direction of the vehicle head light.

With respect to the semiconductor light emitting apparatus to be used as a light source for a vehicle lamp, it is possible to adopt the semiconductor light emitting device provided with the resin layer 4 of a dome shape as shown in Fig. 8A, or with the resin layer 4 having its apex at the edge portion as shown in Figs. 8D and 8E. Furthermore, as shown in Fig. 12C, it is also possible to form such a semiconductor light emitting device where a resin layer 4 with an approximately semi-cylindrical shape at cross section is formed integrally over an arrangement of a plurality of light emitting elements.

Although the description has been given on the reflector type head light, the same kinds of effects can be obtained with a projector type head light as well.

By adopting the semiconductor light emitting apparatus using the semiconductor light emitting devices according to the presently disclosed subject matter as a light source, it is possible to easily form a light distribution pattern having a sharp light-dark boundary, not only in vehicle head lights but also in other cases.

While there has been described what are at present considered to be exemplary embodiments of the invention, it will be understood that various modifications may be made thereto, and it is intended that the appended claims cover such modifications as fall within the true spirit and scope of the invention. All conventional art references described above along with any English translations thereof are herein incorporated in their entirety by reference.

## Claims

1. A semiconductor light emitting device, comprising:
a light emitting element (3) including a semiconductor epitaxial layer (2) which has a light emitting portion and has an upper surface, a lower surface and side surfaces, and an element substrate (1) which supports the semiconductor epitaxial layer (2) and does not transmit light from the light emitting portion; and
a resin layer (4) located on the element substrate (1) and covering the upper surface and at least one of the side surfaces of the semiconductor epitaxial layer (2), the resin layer including at least one of a scattering material (9) and a fluorescent substance (5) that wavelength-converts light from the light emitting portion, a top surface of the resin layer (4) being inclined toward the element substrate when viewed in cross section.

2. The semiconductor light emitting device according to claim 1, wherein
the resin layer (4) is inclined in a form of an approximate arc when viewed in cross section.

3. The semiconductor light emitting device according to claim 2, wherein
the resin layer (4) is configured such that an angle formed between a line tangent to the resin layer (4) and drawn on a starting point of inclination of the resin layer (4), and a surface of the element substrate (1), is at least 20 degrees and does not exceed 90 degrees, at a cross section of the resin layer (4).

4. The semiconductor light emitting device according to claim 2 or 3, wherein
the resin layer (4) is formed by having a resin including at least one of scattering material (9) and fluorescent substance (5) delivered by drops to harden thereafter.

5. The semiconductor light emitting device according to any one of claims 1 to 4, wherein
the resin layer (4) contains a scattering material (9) and a fluorescent substance (5) and the resin layer has a laminated structure composed of a layer containing the scattering material and a layer containing the fluorescent substance.

6. The semiconductor light emitting device according to any one of claims 1 to 5, wherein
the resin layer (4) contains a fluorescent substance (5) which is deposited on the light emitting element (3).

7. The semiconductor light emitting device according claim 6, wherein
the fluorescent substance (5) is deposited on the light emitting element (3) by a sedimentation process.

8. The semiconductor light emitting device according claim 7, wherein
the resin layer (4) contains fluorescent substance (5b) that includes particles having a particle size smaller than a particle size of particles of the fluorescent substance (5a) deposited on the light emitting element (3), the fluorescent substance (5b) with the smaller particle size being dispersed within the resin layer (4).

9. The semiconductor light emitting device according to any one of claims 1 to 8, further comprising:
a plurality of the light emitting elements (3), each of the light emitting elements having a rectangular shape in top planar view, and each of the light emitting elements being arranged in a line such that long sides of the plurality of light emitting elements (3) are formed as a straight line,
wherein the resin layer (4) is inclined toward the element substrate when viewed in a cross section taken perpendicular to a longitudinal direction of each of the light emitting elements (3) arranged in the line.

10. A lighting device, comprising:
the semiconductor light emitting device (100) according to any one of claims 1 to 9; and
a projection device (21) configured to emit an output light from the semiconductor light emitting device (100) in a predetermined direction.

11. The lighting device according to claim 10, wherein
luminance in the vicinity of one long side of the semiconductor light emitting device (100) illuminating an upper side of a light distribution pattern exhibits a maximum value.
